(19) Europäisches Patentamt / European Patent Office / Office européen des brevets

(11) **EP 2 249 479 A1**

(12) **EUROPEAN PATENT APPLICATION**
published in accordance with Art. 153(4) EPC

(43) Date of publication:
**10.11.2010 Bulletin 2010/45**

(51) Int Cl.:
*H03K 5/26* (2006.01)          *G01R 23/10* (2006.01)
*H03L 7/08* (2006.01)          *H03L 7/081* (2006.01)
*H03L 7/099* (2006.01)

(21) Application number: **09718331.3**

(22) Date of filing: **16.02.2009**

(86) International application number:
**PCT/JP2009/000603**

(87) International publication number:
**WO 2009/110172 (11.09.2009 Gazette 2009/37)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **04.03.2008 JP 2008053886**

(71) Applicant: **Panasonic Corporation
Kadoma-shi
Osaka 571-8501 (JP)**

(72) Inventors:
• **KATSUAKI, Abe
   Osaka 540-6207 (JP)**
• **AKIHIRO, Sawada
   Osaka 540-6207 (JP)**
• **SEIICHIRO, Yoshida
   Osaka 540-6207 (JP)**

(74) Representative: **Grünecker, Kinkeldey,
Stockmair & Schwanhäusser
Anwaltssozietät
Leopoldstrasse 4
80802 München (DE)**

(54) **TIME DIGITAL CONVERTER, DIGITAL PLL FREQUENCY SYNTHESIZER, TRANSMITTER-RECEIVER, AND RECEIVER**

(57)     A variable delay circuit (101) generates a plurality of delay signals (D(1), D(2), ... , D(n)). An output holding circuit (102) receives the plurality of delay signals (D(1), D(2), ... , D(n)) in synchronization with a transition of a reference signal (Sref). A selector (104) provides an input signal (Sin) to the variable delay circuit (101) in a normal mode, and provides one of the plurality of delay signals (D(1), D(2), ... , D(n)) to the variable delay circuit (101) in a calibration mode. A frequency measurement circuit (105) counts the number of transitions of one of the plurality of delay signals (D(1), D(2), ... , D(n)) during a predetermined frequency measurement period. In the calibration mode, a delay-amount calibration circuit (106) adjusts a delay time of the variable delay circuit (101) so that the number of transitions counted by the frequency measurement circuit (105) approaches a target value corresponding to a frequency of the input signal (Sin).

FIG.1

## Description

TECHNICAL FIELD

The present disclosure relates to time digital converters which convert time differences between two signals to digital values, and digital PLL frequency synthesizers including the same, and more particularly to technology to adjust delay times of time digital converters.

BACKGROUND ART

In recent years, as miniaturization technology for CMOS process progresses, low-voltage driving, reduction of variation in characteristics, reduction of circuit sizes, etc., have been pursued by digitalization of analog circuits. For example, in Patent Document 1, an all-digital PLL frequency synthesizer is disclosed in which the components, such as a phase-difference detector, a loop filter, etc., are all digitalized. This synthesizer includes a digitally controlled oscillator controllable with discrete numerical information (digital values), instead of a voltage-controlled oscillator controlled by an analog voltage, converts phase information of an oscillation-frequency signal which is output by the digitally controlled oscillator into a numerical value, and calculates a phase difference between the oscillation-frequency signal and a reference-frequency signal using numerical computation. In addition, the all-digital PLL frequency synthesizer disclosed in Patent Document 1 includes a time digital converter (time-to-digital converter), which converts the phase difference between the reference-frequency signal and the oscillation-frequency signal in order to improve the resolution for detecting the phase difference. The time digital converter is applicable in various technical fields as a device to measure a time difference between two signals.

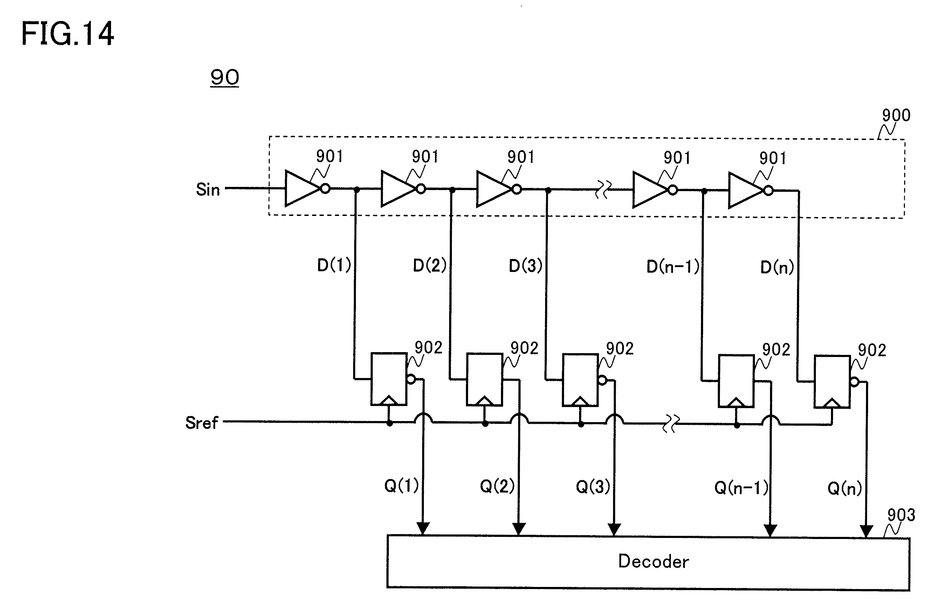

As shown in FIG. 14, in a conventional time digital converter 90, a delay circuit 900 includes a plurality of delay elements 901, 901, ... and generates delay signals D(1), D(2), ... , and D(n) each having a sequentially shifted phase by $\tau$ ($\tau$: the delay time of a delay element 901) by sequentially delaying an input signal Sin. A plurality of flip-flops 902, 902, ... respectively receive the delay signals D(1), D(2), ... , and D(n) in synchronization with a rising edge of a reference signal Sref, and hold the delay signals D(1), D(2), ... , and D(n) as bit values Q(1), Q(2), ... , and Q(n). A decoder 903 outputs a digital value corresponding to a bit sequence formed from the bit values Q(1), Q(2), ... , and Q(n). In this bit sequence, the positions of transition bits (bits having bit values whose signs are different from those of the immediately previous bit values) are uniquely determined by the time difference between the reference signal Sref and the input signal Sin.

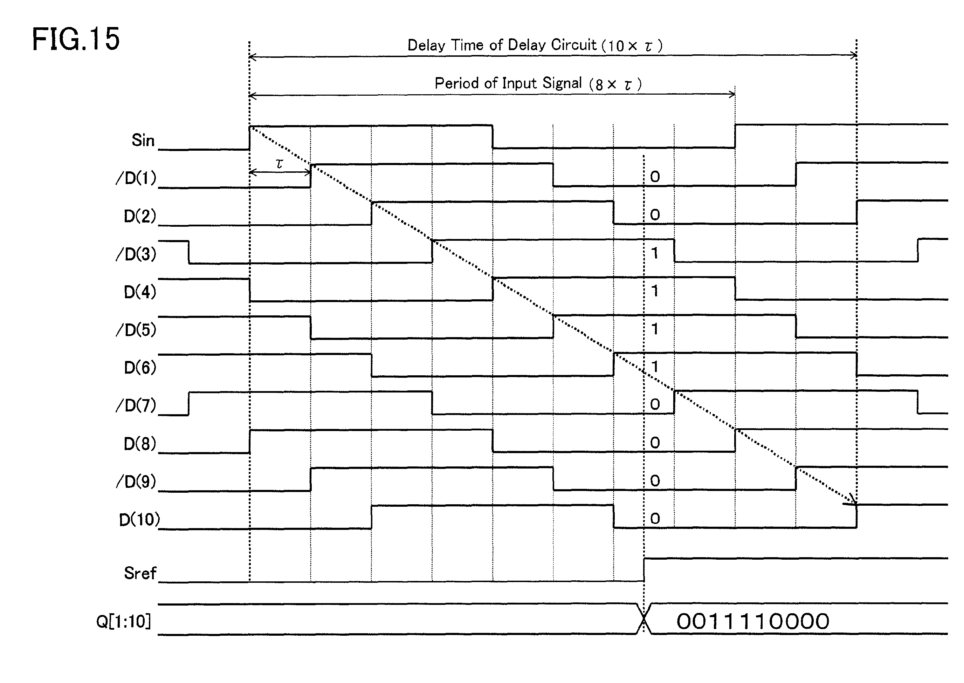

For example, as shown in FIG. 15, a bit sequence "0011110000" is obtained in synchronization with a rising edge of the reference signal Sref. In this bit sequence Q[1:10], the position of a bit value transitioning from "0" to "1" corresponds to the time difference between a rising edge of the reference signal Sref and a falling edge of the input signal Sin, while the position of a bit value transitioning from "1" to "0" corresponds to the time difference between a rising edge of the reference signal Sref and a rising edge of the input signal Sin. Furthermore, discovering the occurrence time points of two rising edges of the input signal Sin enables the period of the input signal Sin to be estimated.

In this way, the time difference between the reference signal Sref and the input signal Sin can be detected at a resolution corresponding to the delay time of a delay element 901. That is, the longer the delay time of each of the delay elements 901, 901, ... is, the lower the resolution for detecting the time difference is.

CITATION LIST

PATENT DOCUMENT

PATENT DOCUMENT 1: Japanese Patent Publication No. 2002-76886

SUMMARY OF THE INVENTION

TECHNICAL PROBLEM

In order to detect a time difference between a reference signal and an input signal, it is important that the delay time of the delay circuit (the total delay time of the delay elements) be adapted to the frequency of the input signal. If the delay time of the delay circuit is too long for the period of the input signal, the resolution for detecting the time difference is coarse, and the accuracy of detecting the time difference is low. Meanwhile, if the delay time of the delay circuit is too short for the period of the input signal, as many bit values as the number corresponding to one period of the input signal cannot be obtained, and thus the period of the input signal cannot be estimated. As such, the time difference between the reference signal and the input signal cannot be detected.

However, if the frequency of the input signal varies widely, it is very difficult to set the delay time of the delay circuit so as to support the entire range of the frequencies. For example, one solution would be to provide more delay elements than are required so that the delay time of the delay circuit will be sufficiently longer than the period of the input signal even when the frequency of the input signal is a minimum value. However, as the number of delay elements increases, the circuit size increases, and the operation by the decoder becomes more complicated as well.

In addition, even if it is designed to set the total delay time of the delay elements to a desired value, the delay time of the delay circuit may not always be the desired value due to variation in characteristics of the circuit elements (variation in a manufacturing process, etc.) and a change in the ambient environment (temperature change, voltage change, etc.). Therefore, the accuracy of detecting a time difference is reduced, and depending on conditions, detection of a time difference may be impossible.

As such, it is an object of the present invention to provide a time digital converter capable of adjusting the delay time to an amount appropriate for the frequency of the input signal, as well as a digital PLL frequency synthesizer, a transceiver, and a receiver each including the same.

SOLUTION TO THE PROBLEM

According to one aspect of the present disclosure, a time digital converter is a device to convert a time difference between a reference signal and an input signal to a digital value, and includes a variable delay circuit configured to generate a plurality of delay signals each having a different phase by sequentially delaying a signal provided thereto, an output holding circuit configured to receive the plurality of delay signals in synchronization with a transition of the reference signal, and to hold the plurality of delay signals as a bit sequence corresponding to the time difference between the reference signal and the signal provided to the variable delay circuit, a selector configured to provide the input signal to the variable delay circuit in a normal mode, and to provide one of the plurality of delay signals to the variable delay circuit so that the variable delay circuit will be in a ring-oscillation state in a calibration mode, a frequency measurement circuit configured to count the number of transitions of the one of the plurality of delay signals during a predetermined frequency measurement period, and a delay-amount calibration circuit configured to, in the calibration mode, adjust a delay time of the variable delay circuit so that the number of transitions counted by the frequency measurement circuit approaches a target value corresponding to a frequency of the input signal. In the above time digital converter, in the normal mode, the output holding circuit holds a bit sequence corresponding to the time difference between the reference signal and the input signal. In addition, since the delay time of the variable delay circuit can be set to an amount appropriate for the frequency of the input signal in the calibration mode, the time difference between the reference signal and the input signal can be properly detected in the normal mode. Accordingly, a wide range of frequencies can be supported, and reduction in the accuracy of detecting the time difference can be prevented.

The variable delay circuit may include a plurality of cascaded variable delay elements, and the selector may provide the input signal to a first one of the variable delay elements in the normal mode, and may provide an output of the one of the plurality of the variable delay elements to the first one of the variable delay elements so that an oscillation loop is formed in the calibration mode.

Preferably, the time digital converter further includes a delay-amount control circuit configured to control the delay time of the variable delay circuit so that the number of transition bits included in a retained result of the output holding circuit falls within an acceptable range. The position of a transition bit in the retained result of the output holding circuit is determined uniquely by the time difference between the reference signal and the input signal. In the above time digital converter, controlling the delay time of the variable delay circuit enables the delay time of the variable delay circuit to be corrected to an amount appropriate for the frequency of the input signal. Accordingly, resistance to a dynamic change of the ambient environment can be improved.

According to another aspect of the present disclosure, a time digital converter is a device to convert a time difference between a reference signal and an input signal to a digital value, and includes a variable delay circuit configured to generate a plurality of delay signals each having a different phase by sequentially delaying the input signal, an output holding circuit configured to receive the plurality of delay signals in synchronization with a transition of the reference signal, and to hold the plurality of delay signals as a bit sequence corresponding to the time difference between the reference signal and the input signal, and a delay-amount control circuit configured to control a delay time of the variable delay circuit so that the number of transition bits included in a retained result of the output holding circuit falls within an acceptable range. In the above time digital converter, since the delay time of the variable delay circuit can be corrected to an amount appropriate for the frequency of the input signal, a wide range of frequencies can be supported, and reduction in the accuracy of detecting the time difference can be prevented. In addition, resistance to a dynamic change of the ambient environment can be improved.

According to still another aspect of the present disclosure, a digital PLL frequency synthesizer is a device to generate an oscillation-frequency signal having a desired frequency, and includes a reference-phase accumulator configured to output a reference-phase value corresponding to the desired frequency, an oscillation-phase accumulator configured to count the number of transitions of the oscillation-frequency signal, and to output the count value as an oscillation-phase value, the time digital converter configured to receive a reference-frequency signal and the oscillation-frequency signal respectively as the reference signal and the input signal, and to output a digital value corresponding to a time difference between the reference-frequency signal and the oscillation-frequency signal, a phase-difference detector configured to set a phase-difference value based on both a difference between the reference-phase value from the reference-phase accumulator and the oscillation-phase value from the oscillation-phase accumulator, and a difference between the reference-phase value and the digital value from the time digital converter, and a digitally controlled oscillator configured to set a frequency of the oscillation-frequency signal depending on the phase-difference value. In the above digital PLL frequency synthesizer, since the delay time of the variable delay circuit can be adjusted to a desired value (an amount appropriate for the frequency of the oscillation-frequency signal), a frequency variable range of the oscillation-frequency signal can be broadened, and phase noise can be further reduced.

ADVANTAGES OF THE INVENTION

As described above, since the delay time can be adjusted to an amount appropriate for the frequency of the input signal, a wide range of frequencies can be supported, and reduction in the accuracy of detecting the time difference can be prevented.

BRIEF DESCRIPTION OF THE DRAWINGS

[FIG. 1] FIG. 1 is a diagram illustrating by way of example a configuration of a time digital converter according to the first embodiment.
[FIG. 2] FIG. 2 is a timing chart for illustrating a time-to-digital conversion operation by the time digital converter shown in FIG. 1.
[FIG. 3] FIG. 3 is a flowchart for illustrating a calibration operation by the time digital converter shown in FIG. 1.
[FIG. 4] FIG. 4 is a graph illustrating by way of example a corresponding relationship between an input frequency and a delay time of a delay element.
[FIG. 5] FIG. 5 is a graph illustrating by way of example a corresponding relationship between a desired delay time of a delay element and a ring-oscillation frequency.
[FIG. 6] FIG. 6 is a flowchart for illustrating a variation of the calibration operation shown in FIG. 3.
[FIG. 7] FIG. 7 is a diagram for illustrating a variation of the time digital converter shown in FIG. 1.
[FIG. 8] FIG. 8 is a diagram illustrating by way of example a configuration of a time digital converter according to the second embodiment.
[FIG. 9] FIG. 9 is a timing chart for illustrating an operation by an excessive-delay detection section.
[FIG. 10] FIG. 10 is a timing chart for illustrating an operation by an insufficient-delay detection section.
[FIG. 11] FIG. 11 is a diagram for illustrating a variation of the delay-amount control circuit shown in FIG. 8.
[FIG. 12] FIG. 12 is a diagram illustrating by way of example a configuration of an all-digital PLL frequency synthesizer including the time digital converter shown in FIG. 1.
[FIG. 13] FIG. 13 is a diagram illustrating by way of example a configuration of a transceiver including the all-digital PLL frequency synthesizer shown in FIG. 12.
[FIG. 14] FIG. 14 is a diagram illustrating a configuration of a conventional time digital converter.
[FIG. 15] FIG. 15 is a timing chart for illustrating an operation by the time digital converter shown in FIG. 14.

DESCRIPTION OF EMBODIMENTS

Example embodiments of the present disclosure will be described below in detail with reference to the drawings. Note that like reference characters indicate the same or similar components, and the explanation thereof will not be repeated.

(First Embodiment)

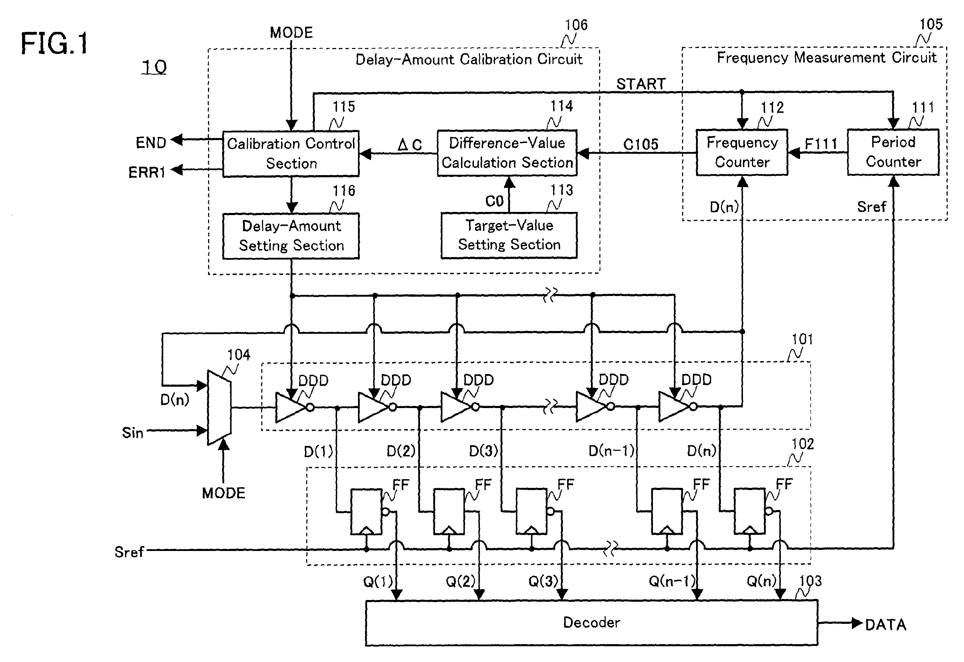

FIG. 1 illustrates an example configuration of a time digital converter (time-to-digital converter) according to the first embodiment of the present disclosure. The time digital converter 10 converts a time difference (here, a time difference between rising edges) between a reference signal Sref and an input signal Sin to a digital data DATA. In addition, the time digital converter 10 performs a calibration operation in order to set a delay time of a variable delay circuit 101 to an amount appropriate for the frequency of the input signal Sin. The time digital converter 10 includes the variable delay circuit 101, an output holding circuit 102, a decoder 103, a selector 104, a frequency measurement circuit 105, and a delay-amount calibration circuit 106.

[Variable Delay Circuit]

The variable delay circuit 101 includes n (where n is an integer more than one) cascaded delay elements DDD, DDD, ... , and generates n delay signals D(1), D(2), ... , and D(n) each having a different phase by sequentially delaying a signal provided from the selector 104. Note that, here, the delay elements DDD, DDD, ... are each formed of an inverter, and "n" denotes an odd number greater than or equal to three. That is, odd-numbered ones of the delay elements DDD, DDD, ... respectively output delay signals D(1), D(3), ... , and D(n) each having an opposite polarity to that of the signal from the selector 104.

[Output Holding Circuit]

The output holding circuit 102 includes n flip-flops FF, FF, ... receives the plurality of delay signals D(1), D(2), ... , and D(n) from the variable delay circuit 101 in synchronization with a transition (here, a rising edge) of the reference signal Sref, and holds the plurality of delay signals D(1), D(2), ... , and D(n) as n bit values Q(1), Q(2), ... , and Q(n). Note that, here, in order to revert the odd-numbered delay signals D(1), D(3), ... , and D(n) back to the original polarity, the decoder 103 is connected with inverted output terminals (i.e., NQ terminals) of the odd-numbered flip-flops FF. Meanwhile, since the delay signals D(2), D(4), ... , and D(n-1) have a same polarity as that of the signal from the selector 104, the decoder 103 is connected with non-inverted output terminals (i.e., Q terminals) of the even-numbered flip-flops FF. Note that the number of the flip-flops FF may be equal to or less than the number of the delay elements DDD.

[Decoder]

The decoder 103 outputs a digital value DATA corresponding to a retained result (an n-bit sequence formed of the n bit values Q(1), Q(2), ... , and Q(n)) of the output holding circuit 102. In the retained result of the output holding circuit 102, the positions of transition bits (bits having bit values whose signs are different from those of the immediately previous bit values) are uniquely determined by the time difference between the reference signal Sref and the input signal Sin. That is, the times of occurrences of rising and falling edges of the input signal Sin, and the period value of the input signal Sin can be obtained based on the positions of transition bits in the retained result of the output holding circuit 102.

[Selector]

The selector 104 switches between a normal mode to perform a time-to-digital conversion operation and a calibration mode to adjust the delay time of the variable delay circuit 101 in response to a mode control signal MODE from a control circuit (not shown). When set to the normal mode, the selector 104 provides the input signal Sin to the variable delay circuit 101 (a first delay element DDD). This causes a time-to-digital conversion operation to be performed in the variable delay circuit 101, in the output holding circuit 102, and in the decoder 103. Meanwhile, when set to the calibration mode, the selector 104 provides the nth delay signal D(n) to the variable delay circuit 101. In this way, the n delay elements DDD, DDD, ... (here, an odd number of inverters) are connected in a loop, thereby causing the variable delay circuit 101 to be in a ring-oscillation state.

[Frequency Measurement Circuit]

The frequency measurement circuit 105 counts the number of transitions of one of the n delay signals D(1), D(2), ... , and D(n) during a predetermined frequency measurement period. Here, the frequency measurement circuit 105 counts the number of occurrences of rising edges of the nth delay signal D(n). The frequency measurement circuit 105 includes a period counter 111 and a frequency counter 112. The period counter 111 counts the number of transitions (here, the number of occurrences of rising edges) of the reference signal Sref. The frequency counter 112 starts to count the number of transitions of the delay signal D(n) upon a start of counting by the period counter 111, and outputs a count result (a frequency count value C105) when the count value of the period counter 111 reaches a period-setting value (a value for setting the frequency measurement period).

[Delay-Amount Calibration Circuit]

The delay-amount calibration circuit 106 switches between the normal mode and the calibration mode in response to the mode control signal MODE. When set to the calibration mode, the delay-amount calibration circuit 106 adjusts the delay time of the variable delay circuit 101 (more specifically, the delay time of each of the delay elements DDD, DDD, ...) so that the number of transitions counted by the frequency measurement circuit 105 approaches a target value. The delay-amount calibration circuit 106 includes a target-value setting section 113, a difference-value calculation section 114, a calibration control section 115, and a delay-amount setting section 116.

The target-value setting section 113 sets a target value (a target count value C0) of the number of transitions of the delay signal D(n). The target value of the number of transitions is a value corresponding to the frequency of the input signal Sin, and more specifically, is equivalent to the number of transitions counted by the frequency measurement circuit 105 when the delay time of the variable delay circuit 101 is set to a desired value (an amount appropriate for frequency of the input signal Sin). The difference-value calculation section 114 calculates a difference value $\Delta C$ between the number of transitions counted by the frequency measurement circuit 105 and the target value set by the target-value setting section 113. The calibration control section 115 controls the period counter 111, the frequency counter 112, and the delay-amount setting section 116 in response to the mode control signal MODE. In addition, the calibration control section 115 performs control of the delay-amount setting section 116, decision on a calibration error, etc., based on the difference value $\Delta C$ calculated by the difference-value calculation section 114. The delay-amount setting section 116 sets the delay time of the variable delay circuit 101 in response to the control by the calibration control section 115. For example, the delay-amount setting section 116 changes the delay time of each delay element DDD by increasing or decreasing a bias current for each delay element DDD. The higher the bias current for each delay element DDD is, the more the delay time of each delay element DDD is reduced. Alternately, the delay time of each delay element DDD may be changed by increasing or decreasing a load capacitance of each delay element DDD. Note that, it is assumed here that the delay-amount setting section 116 changes the delay time of the variable delay circuit 101 in a stepwise fashion.

[Time-to-Digital Conversion Operation]

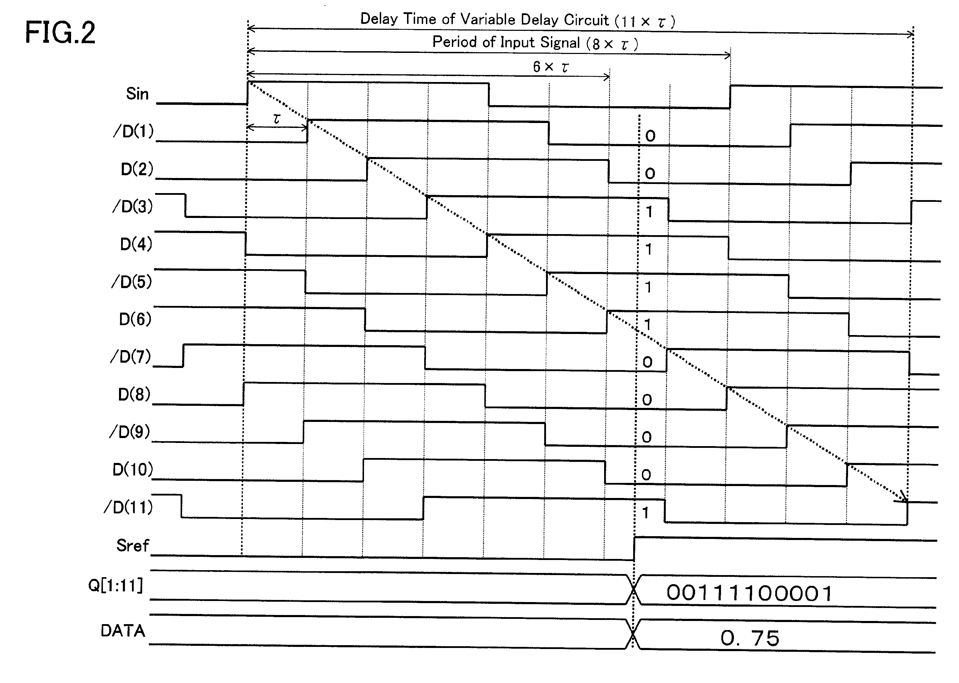

Next, referring to FIG. 2, a time-to-digital conversion operation by the time digital converter 10 will be described. Note that, it is assumed here that n = 11, and the delay time of each of the delay elements DDD, DDD, ... is "$\tau$." In addition, in FIG. 2, the odd-numbered delay signals D(1), D(3), ... , and D(11) are shown inverted for purposes of illustration.

The variable delay circuit 101 sequentially delays the input signal Sin to generate eleven delay signals D(1), D(2), ... , and D(11) each having a sequentially shifted phase by $\tau$. The flip-flops FF, FF, ... respectively receive the delay signals D(1), D(2), ... , and D(11) in synchronization with a rising edge of the reference signal Sref. Thus, bit values Q(1), Q(2), ... , and Q(11) corresponding to the time difference between the reference signal Sref and the input signal Sin are obtained.

Here, the retained result Q[1:11] of the output holding circuit 102 appears as "001111000001." The sign of the retained result Q[1:11] transitions from "1" to "0" at the seventh bit value. This indicates that a rising edge of the reference signal Sref occurs when a time period of "6 * $\tau$" has elapsed after an occurrence of a rising edge of the input signal Sin. In addition, the sign of the retained result Q[1:11] transitions from "0" to "1" at the third and the eleventh bit values. This indicates that the period of the input signal Sin is equivalent to "8 * $\tau$." In this regard, denoting the period of the input signal Sin as "Tin," the input signal Sin is advanced by "0.75 * Tin (= 6/8 * Tin)" with respect to the reference signal Sref. The decoder 103 outputs a digital value DATA representing "0.75." In this way, the time digital converter 10 outputs the digital value DATA corresponding to the time difference between the reference signal Sref and the input signal Sin.

[Calibration Operation]

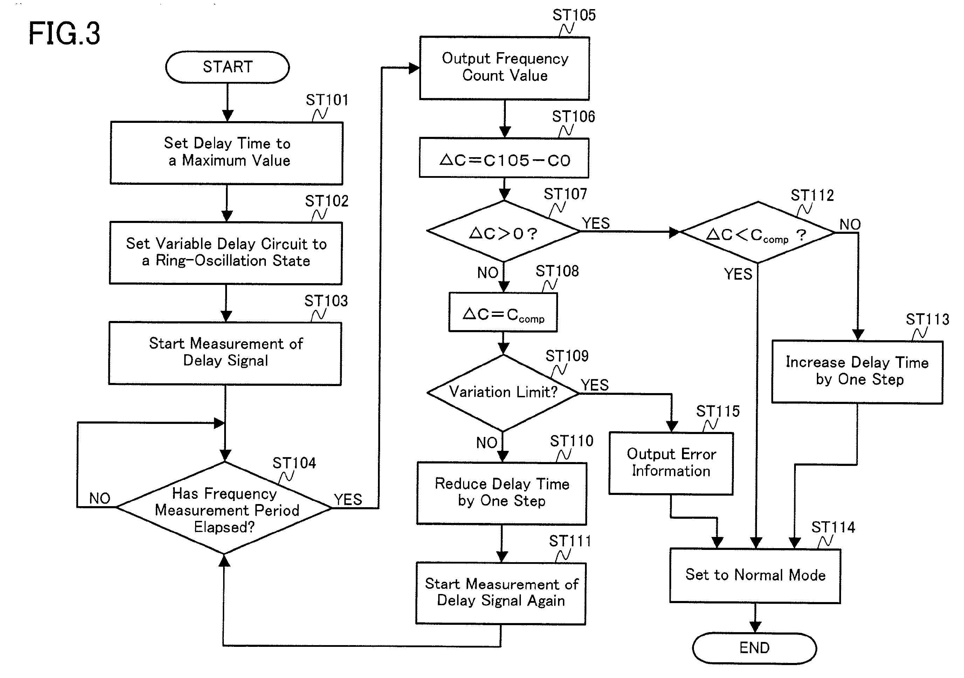

Next, referring to FIG. 3, a calibration operation by the time digital converter 10 shown in FIG. 1 will be described. To allow the calibration operation to be performed, a control circuit (not shown) provides the mode control signal MODE which represents the calibration mode. This causes the selector 104 and the delay-amount calibration circuit 106 to be set to the calibration mode.

<Step ST101>

The calibration control section 115 initializes the delay-amount setting section 116 in response to the mode control signal MODE. This causes the delay-amount setting section 116 to set the delay time of the variable delay circuit 101 to an initial value (here, a maximum value).

<Step ST102>

In response to the mode control signal MODE, the selector 104 selects and provides the delay signal D(n) to a first delay element DDD of the variable delay circuit 101. This causes the variable delay circuit 101 to be set to a ring-oscillation state. A ring-oscillation frequency (i.e., the frequency of the delay signal D(n)) can be expressed as [Eq. 1].

$$f_{ring} = 1 / (\tau * n * 2) \qquad ... [Eq. 1]$$

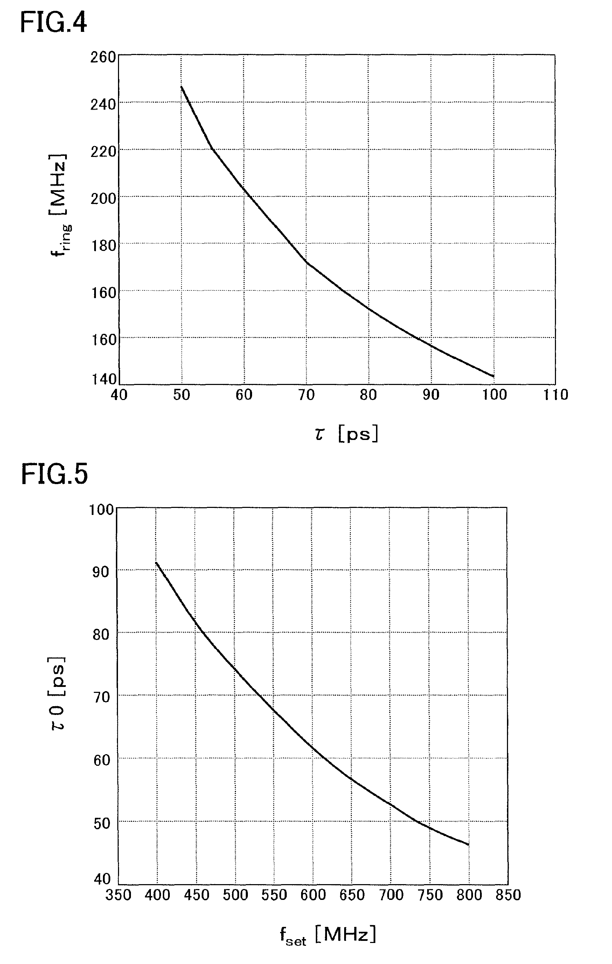

where
$f_{ring}$: ring-oscillation frequency [Hz],
$\tau$: delay time per delay element [sec], and
n: number of the delay elements.
As shown in [Eq. 1], as the time delay of the variable delay circuit 101 "$\tau * n$" increases, the ring-oscillation frequency "$f_{ring}$" decreases. If the number of the delay elements is a fixed value, the longer the delay time per delay element "$\tau$" is, the lower the ring-oscillation frequency "$f_{ring}$" is, as shown in FIG. 4. Note that n = 41 in FIG. 4.

<Step ST103>

Next, the calibration control section 115 outputs a count-start signal START to the period counter 111 and the frequency counter 112 to reset the respective count values of the period counter 111 and the frequency counter 112 to "0." This causes measurement of the number of transitions of the delay signal D(n) to start.

<Step ST104>

The period counter 111 increments the count value in synchronization with a rising edge of the reference signal Sref, and sets a count-complete flag F111 when the count value reaches the period-setting value. In this way, the period counter 111 sets the frequency measurement period. The frequency measurement period can be expressed as [Eq. 2].

$$Tc = C_{ref} / f_{ref} \qquad ... [Eq. 2]$$

where
Tc: frequency measurement period [sec],
$f_{ref}$: reference frequency (frequency of the reference signal Sref) [Hz], and
$C_{ref}$: period-setting value.
As shown in [Eq. 2], by setting the reference frequency "$f_{ref}$" and the period-setting value "$C_{ref}$," the frequency measurement period "Tc" can be determined. Note that the frequency measurement period may be set based on another signal instead of the reference signal Sref.

<Step ST105>

The frequency counter 112 increments the count value in synchronization with a rising edge of the delay signal D(n), and outputs the count value to the delay-amount calibration circuit 106 as the frequency count value C105 when the count-complete flag F 111 is set by the period counter 111. The frequency count value C105 (i.e., the number of transitions of the delay signal D(n) during a frequency measurement period) can be expressed as [Eq. 3].

$$C_{ring} = Tc * f_{ring} \qquad ... [Eq. 3]$$

where
$C_{ring}$: frequency count value,
Tc: frequency measurement period [sec], and
$f_{ring}$: ring-oscillation frequency [Hz].
As shown in [Eq. 3], as the ring-oscillation frequency "$f_{ring}$" decreases, the frequency count value "$C_{ring}$" decreases.

<Step ST106>

Next, the difference-value calculation section 114 subtracts the target value (target count value C0) set by the target-value setting section 113 from the frequency count value C105 from the frequency counter 112, thereby calculates the difference value $\Delta C$ (= C105 - C0). The target count value C0 is equivalent to the frequency count value C105 when the delay time of the variable delay circuit 101 is set to a desired value. The target count value C0 can be expressed as [Eq. 4].

$$C0 = Tc * f_{ring} = Tc / (\tau 0 * n * 2) \qquad ... [Eq. 4]$$

where
Tc: frequency measurement period [sec],
$\tau 0$: desired delay time per delay element [sec], and
n: number of the delay elements.

As shown in [Eq. 4], determination of the desired delay time per delay element "$\tau 0$," the number of the delay elements (more specifically, the number of the delay elements which form an oscillation loop) "n," and the frequency measurement period "Tc" enables the target count value C0 to be set.

Next, a desired value of the delay time of the variable delay circuit 101 will be described. In order to detect a time difference in the time-to-digital conversion operation, the delay time of the variable delay circuit 101 is set to a predetermined multiple of the period of the input signal Sin. That is, the desired delay time of the variable delay circuit 101 "$\tau 0 * n$" can be expressed as the following [Eq. 5].

$$\tau 0 * n = K / f_{ring} \qquad ... [Eq. 5]$$

where
$\tau 0$: desired delay time per delay element [sec],
n: number of the delay elements,
K: delay multiplication factor, and
$f_{set}$: input frequency (frequency of the input signal Sin) [Hz].

Note that "delay multiplication factor" represents the multiplication factor for the desired delay time of the variable delay circuit 101 with respect to one period of the input signal Sin. As shown in [Eq. 5], determination of the input frequency "$f_{set}$," the delay multiplication factor "K," and the number of the delay elements "n" enables the desired delay time per delay element "$\tau 0$" to be set. If the delay multiplication factor and the number of the delay elements are fixed values, then as the input frequency "$f_{set}$" decreases, the desired delay time "$\tau 0$" increases, as shown in FIG. 5. Note that n = 41 and K = 1.5 in FIG. 5.

In addition, using [Eq. 1], [Eq. 4], and [Eq. 5]:

$$C0 = Tc * \{f_{set} / (K * 2)\} \qquad ... [Eq. 6]$$

As shown in [Eq. 6], determination of the frequency measurement period "Tc," the input frequency "$f_{set}$," and the delay multiplication factor "K" enables the target count value C0 to be set.

<Step ST107>

Next, the calibration control section 115 determines whether the difference value $\Delta C$ calculated by the difference-value calculation section 114 is larger than "0" or not. If the difference value $\Delta C$ is larger than "0," the process proceeds to step ST112; otherwise, it proceeds to step ST108.

<Step ST108>

Next, the calibration control section 115 sets the difference value $\Delta C$ calculated by the difference-value calculation section 114 as a comparison value $C_{comp}$. The comparison value $C_{comp}$ is used to compare the current difference value ΔC with the next difference value ΔC.

<Step ST109>

In addition, the calibration control section 115 checks to what value the delay time is set by the delay-amount setting section 116, and determines whether the delay time of the variable delay circuit 101 is set to a limit value of the variable range (here, a minimum value) or not. For example, the calibration control section 115 determines whether the bias current is set to a maximum value by the delay-amount setting section 116 or not. If the delay time of the variable delay circuit 101 is set to the limit value of the variable range, the process proceeds to step ST115; otherwise, it proceeds to step ST110.

<Step ST110>

Next, the calibration control section 115 controls the delay-amount setting section 116 so that the delay time of the variable delay circuit 101 is reduced by one step.

<Step ST111>

Next, the calibration control section 115 again outputs the count-start signal START to the period counter 111 and the frequency counter 112 to reset the respective count values of the period counter 111 and the frequency counter 112 to "0." This causes measurement of the delay signal D(n) to be started again. Then, the process proceeds to step ST104.

<Step ST112>

Meanwhile, if the difference value ΔC is greater than "0" at step ST107, the calibration control section 115 compares the difference value ΔC with the comparison value $C_{comp}$ (i.e., the previous difference value ΔC). This comparison enables determination of which of the current frequency count value C105 and the previous frequency count value C105 is nearer to the target count value C0. If the difference value ΔC is less than the comparison value $C_{comp}$, the process proceeds to step ST114; otherwise, the process proceeds to step ST113.

<Step ST113>

If the difference value ΔC is greater than the comparison value $C_{comp}$, it means that the previous frequency count value C105 is nearer to the target count value C0 than the current frequency count value C105. The calibration control section 115 controls the delay-amount setting section 116 so that the delay time of the variable delay circuit 101 is increased by one step. This causes the delay time of the variable delay circuit 101 to return to the previous set value.

<Step ST114>

Next, the calibration control section 115 outputs a setting-complete signal END representing that the setting operation of the delay time of the variable delay circuit 101 has been completed. Accordingly, a mode control signal MODE which represents the normal mode is provided from the control circuit (not shown), thus the selector 104 and the delay-amount calibration circuit 106 are set to the normal mode. In response to the mode control signal MODE, the selector 104 selects and provides the input signal Sin to the variable delay circuit 101. Accordingly, a time-to-digital conversion operation is performed.

<Step ST115>

Meanwhile, if the delay time of the variable delay circuit 101 has been set to the limit value of the variable range at step ST109 (i.e., if the delay time of the variable delay circuit 101 cannot be reduced any more), the calibration control section 115 outputs calibration error information ERR1 indicating that the delay time of the variable delay circuit 101 cannot be adjusted. Then, the process proceeds to step ST114.
In this way, by decreasing the delay time of the variable delay circuit 101 in a stepwise fashion to minimize the difference between the frequency count value C105 and the target count value C0, the delay time of the variable delay circuit 101 is set to an amount appropriate for the frequency of the input signal Sin.
As described above, setting the delay time of the variable delay circuit 101 to an amount appropriate for the frequency of the input signal Sin in the calibration mode allows the time difference between the reference signal Sref and the input signal Sin to be properly detected in the normal mode. Accordingly, a wide range of frequencies can be supported, and reduction in the accuracy of detecting the time difference can be prevented.

In addition, by outputting the calibration error information ERR1, the fact that the delay time of the variable delay circuit 101 cannot be adjusted can be provided to the outside (e.g., a user, a main controller, etc.). Therefore, the performance quality of the time digital converter can be confirmed, and for example, decision of rejection can be made when shipping from the factory.

[Variation of Variable Delay Circuit]

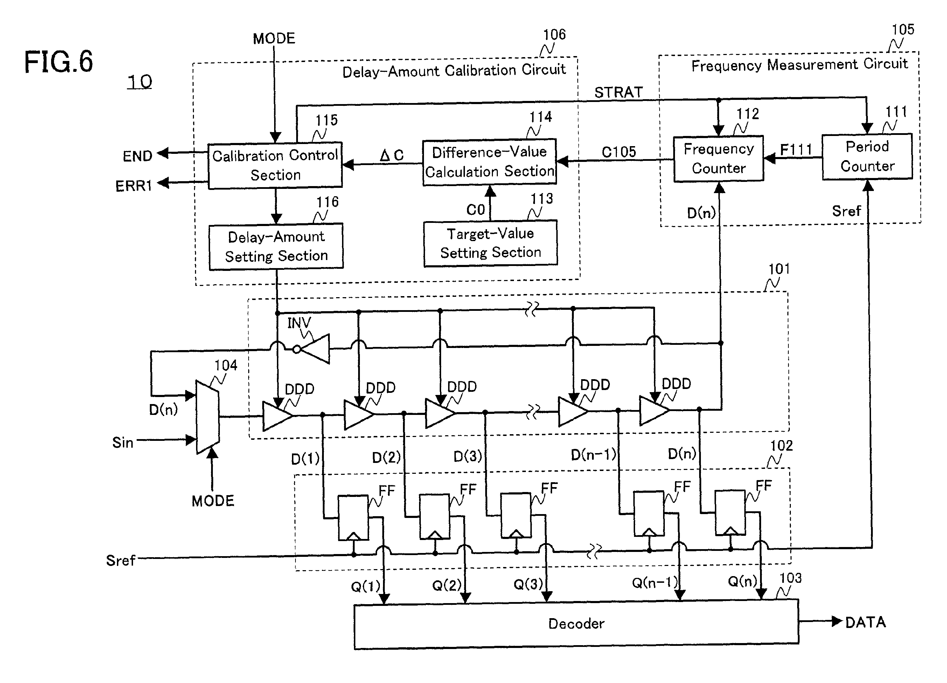

In the calibration mode, the selector 104 may provide the output of another odd-numbered one of the inverters, instead of the output of the last inverter, to the first inverter. Alternately, the time digital converter 10 may be configured such that another inverter to invert the output of an even-numbered inverter is further provided in the variable delay circuit 101, and the selector 104 provides the output of the another inverter to the first inverter. Moreover, each delay element DDD may be formed of, not an inverter, but a buffer or a logic element (NOR circuit, etc.). For example, as shown in FIG. 6, if the delay elements DDD are buffers, an inverter INV to invert the output of one of the plurality of the buffers may be further provided in the variable delay circuit 101, and the output of the inverter INV may be provided to the first buffer by the selector 104. In this case, since there is no need to invert the polarity of the delay signals, the decoder 103 can be simply connected with the respective non-inverted output terminals of the flip-flops FF, FF, ... Thus, if the variable delay circuit 101 and the selector 104 are configured so that an oscillation loop is formed in the calibration mode, the variable delay circuit 101 can be set to a ring-oscillation state.

[Variation of Calibration Operation]

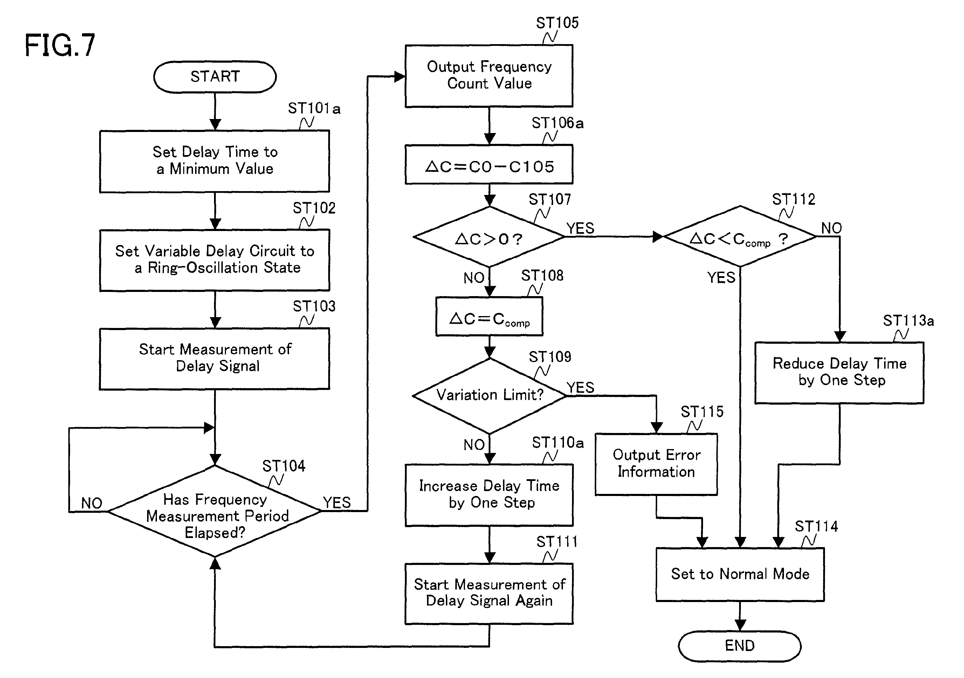

As shown in FIG. 7, the delay time of the variable delay circuit 101 may be increased in a stepwise fashion (step ST110a) after setting the delay time of the variable delay circuit 101 to a minimum value (step ST101a). In this case, the difference value $\Delta C$ is calculated by subtracting the frequency count value C105 from the target count value C0 (step ST106a). In addition, if the difference value $\Delta C$ is larger than or equal to the comparison value $C_{comp}$, the delay time of the variable delay circuit 101 is decreased by one step (step ST113a). Also in this case, the delay time of the variable delay circuit 101 can be adjusted so that the number of transitions counted by the frequency measurement circuit 105 approaches a target value. As described above, the steps of the calibration operation may be changed as appropriate. Moreover, other steps may be added for functionality enhancement and performance improvement.

[Setting of Target Count Value]

In order to set the target count value C0, the target-value setting section 113 may calculate the target count value C0 using a calculation formula such as [Eq. 6]. In addition, the target-value setting section 113 may store in advance a corresponding relationship between the target count value C0 and the input frequency "$f_{set}$" as tabular data, and may read the target count value corresponding to a set input frequency. Moreover, if the target count value C0 is set in consideration of, not only the delay time of each of the delay elements DDD, DDD, ... , but also delay times of other delaying elements (the selector 104, wires connecting between delay elements, etc.), the delay time of the variable delay circuit 101 can be adjusted more precisely.

(Second Embodiment)

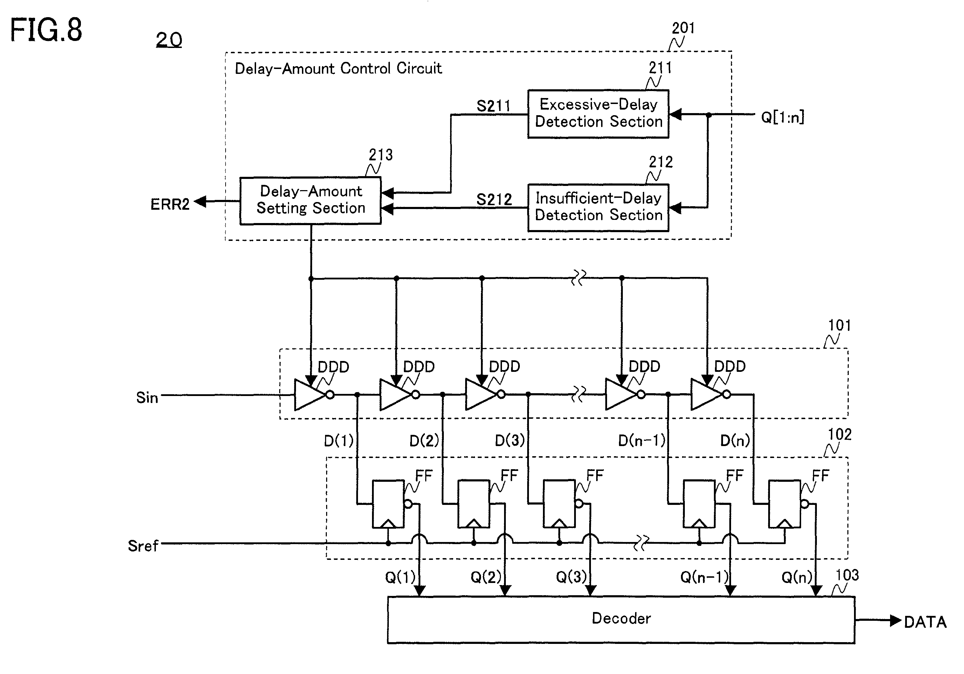

FIG. 8 illustrates a configuration of a time digital converter according to the second embodiment of the present disclosure. The time digital converter 20 includes a delay-amount control circuit 201 instead of the selector 104, the frequency measurement circuit 105, and the delay-amount calibration circuit 106 shown in FIG. 1. The other part of the configuration is similar to that of FIG. 1. The delay-amount control circuit 201 controls the delay time of the variable delay circuit 101 so that the number of transition bits included in the retained result Q[1:n] of the output holding circuit 102 falls within an acceptable range. The retained result Q[1:n] is a bit sequence including n bit values Q(1), Q(2), ... , and Q(n). The delay-amount control circuit 201 includes an excessive-delay detection section 211, an insufficient-delay detection section 212, and a delay-amount setting section 213.

[Detection of Excessive Delay]

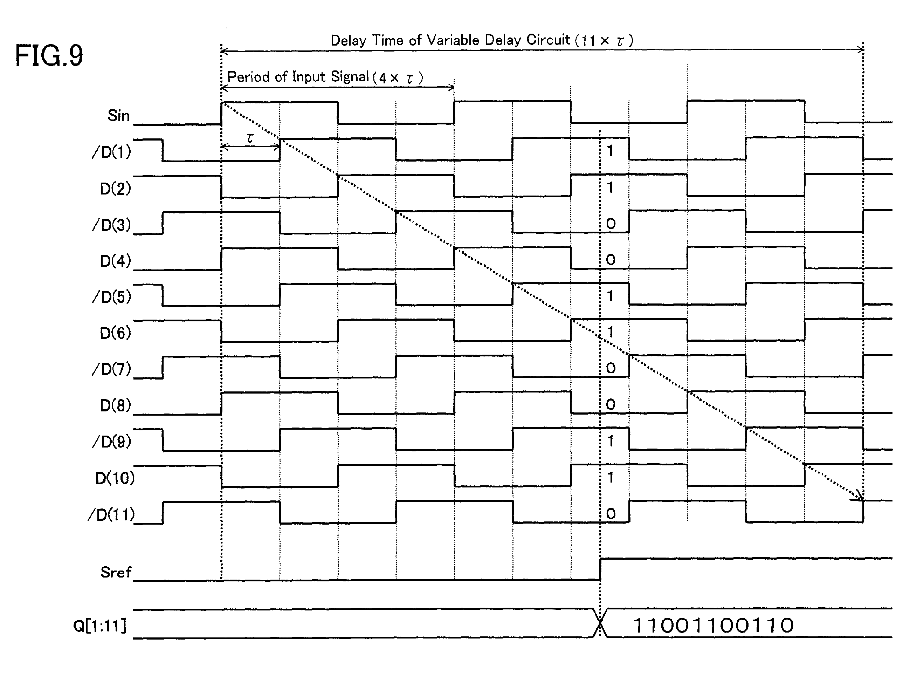

As shown in FIG. 9, if the delay time of the variable delay circuit 101 is excessive (i.e., if the delay time of the variable delay circuit 101 is too long for the period of the input signal Sin), the resolution for detecting the time difference becomes coarse, and many transition bits are included in the retained result Q[1:n] of the output holding circuit 102. For example, if the frequency of the input signal Sin is "800 MHz," the number of the delay elements is "41," the delay time per delay element is "100 ps (picoseconds)," then the delay multiplication factor (K) is calculated as follows:

$$K = \tau * n * f_{in} = 100 * 10^{-12} * 41 * 800 * 10^{6} = 3.28$$

where
$\tau$: desired delay time per delay element [sec],
n: number of the delay elements, and
$f_{in}$: frequency of the input signal Sin [Hz].

As shown above, since the delay time of the variable delay circuit 101 is more than three times larger than one period of the input signal Sin, the retained result Q[1:41] is estimated to include six transition bits. In this situation, the resolution for detecting the time difference is about one third of the period of the input signal Sin, thereby leading to large quantization noise, and the accuracy of detecting a time difference is reduced.

When it is detected that the number of transition bits included in the retained result Q[1:n] is greater than an excessive-delay threshold (a criteria value for determining whether the delay time is excessive), the excessive-delay detection section 211 outputs an excessive-delay detection signal S211. When the delay-amount setting section 213 receives the excessive-delay detection signal S211, the delay-amount setting section 213 reduces the delay time of the variable delay circuit 101. This can prevent reduction in the accuracy of detecting the time difference.

[Detection of Insufficient Delay]

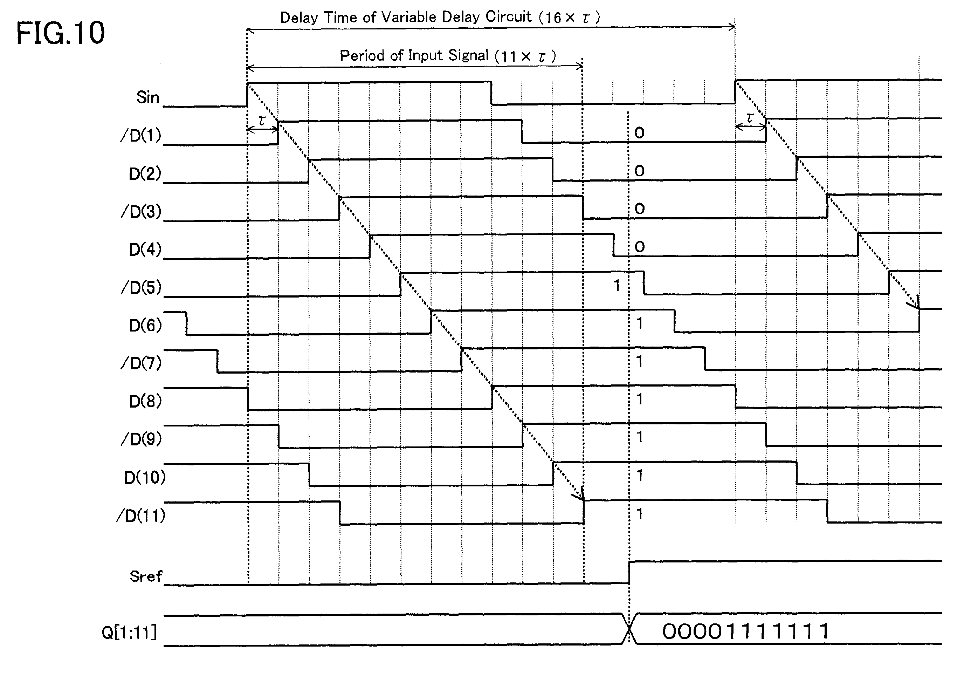

Meanwhile, as shown in FIG. 10, if the delay time of the variable delay circuit 101 is insufficient (i.e., if the delay time of the variable delay circuit 101 is too short for the period of the input signal Sin), the number of transition bits included in the retained result Q[1:n] is small. For example, if the delay time of the variable delay circuit 101 is less than or equal to the period of the input signal Sin, the number of transition bits is less than three. In this situation, the retained result Q[1:n] of the output holding circuit 102 does not include as many bit values as the number corresponding to one period of the input signal Sin, thereby disabling the decoder 103 from estimating the period of the input signal Sin. Therefore, the time difference cannot be detected.

When it is detected that the number of transition bits included in the retained result Q[1:n] is less than an insufficient-delay threshold (a criteria value for determining whether the delay time is insufficient), the insufficient-delay detection section 212 outputs an insufficient-delay detection signal S212. When the delay-amount setting section 213 receives the insufficient-delay detection signal S212, the delay-amount setting section 213 increases the delay time of the variable delay circuit 101. Accordingly, the delay time of the variable delay circuit 101 can be longer than one period of the input signal Sin, thereby enabling the time difference between the reference signal Sref and the input signal Sin to be detected.

[Detection of Control Error]

In addition, when it is detected that the delay time of the variable delay circuit 101 cannot be increased or decreased, the delay-amount setting section 213 outputs control error information ERR2 indicating that control of the delay time of the variable delay circuit 101 is not possible. Specifically, when the delay-amount setting section 213 receives the excessive-delay detection signal S211 while the delay time of the variable delay circuit 101 is set to the minimum value, the delay-amount setting section 213 outputs the control error information ERR2. Similarly, when the delay-amount setting section 213 receives the insufficient-delay detection signal S212 while the delay time of the variable delay circuit 101 is set to the maximum value, the delay-amount setting section 213 outputs the control error information ERR2.

As described above, by dynamically controlling the delay time of the variable delay circuit 101, the delay time of the variable delay circuit 101 can be corrected to an amount appropriate for the frequency of the input signal Sin. Accordingly, a wider range of frequencies than that of conventional ones can be supported, and reduction in the accuracy of detecting the time difference can be prevented. In addition, even if the delay time of the variable delay circuit 101 changes due to a dynamic change of the ambient environment (temperature change, voltage change, etc.), the time-to-digital conversion operation can be properly performed. As such, resistance to a dynamic change of the ambient environment can be improved.

Moreover, by outputting the control error information ERR2, the fact that the delay time of the variable delay circuit 101 cannot be controlled can be provided to the outside (e.g., a user, a main controller, etc.). Therefore, the performance quality of the time digital converter can be confirmed, and for example, decision of rejection can be made when shipping from the factory.

Note that when counting the number of transition bits in the retained result Q[1:n] of the output holding circuit, both bit values transitioning from "0" to "1" and bit values transitioning from "1" to "0" may be counted, or only either bit values may be counted.

Furthermore, the time digital converter 20 may further include, in addition to the components shown in FIG. 8, the selector 104, the frequency measurement circuit 105, and the delay-amount calibration circuit 106 shown in FIG. 1. In this case, it is suggested that, in a calibration operation, calibration of the delay time be performed by the selector 104, the frequency measurement circuit 105, and the delay-amount calibration circuit 106; and in a normal operation, dynamic control of the delay time be performed by the delay-amount control circuit 201.

[Variation of Delay-Amount Control Circuit]

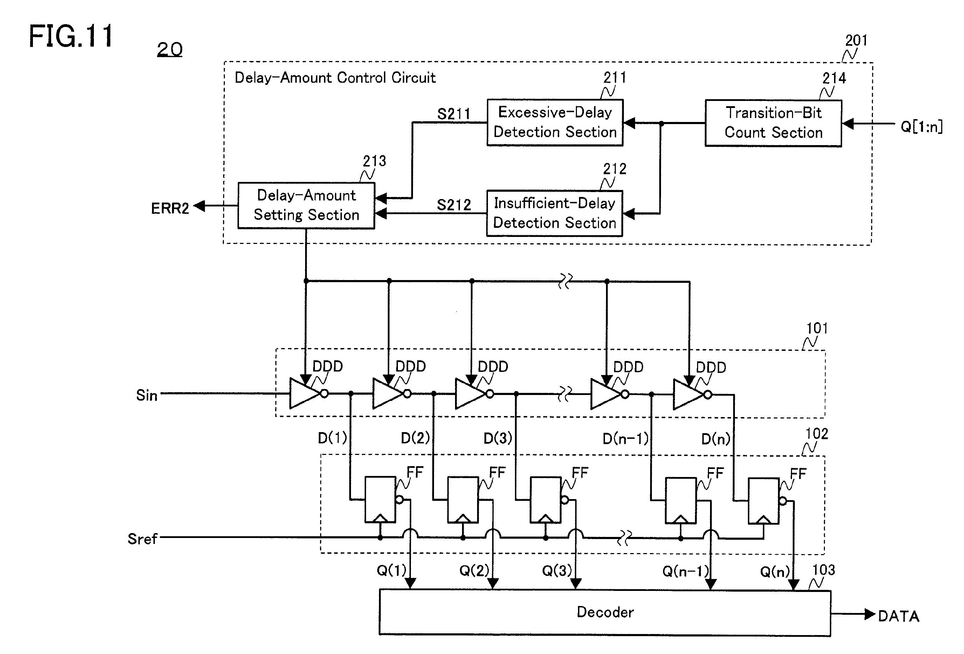

In addition, as shown in FIG. 11, the delay-amount control circuit 201 may further include a transition-bit count section 214 which counts the number of transition bits included in the retained result Q[1:n] of the output holding circuit 102. In this delay-amount control circuit 201, the excessive-delay detection section 211 and the insufficient-delay detection section 212 respectively compare the numbers of transition bits counted by the transition-bit count section 214, and the predetermined values (the excessive-delay threshold and the insufficient-delay threshold). Note that the delay-amount control circuit 201 does not necessarily need to include both the excessive-delay detection section 211 and the insufficient-delay detection section 212, but may be configured so as to include only one of them.

(All-Digital PLL Frequency Synthesizer)

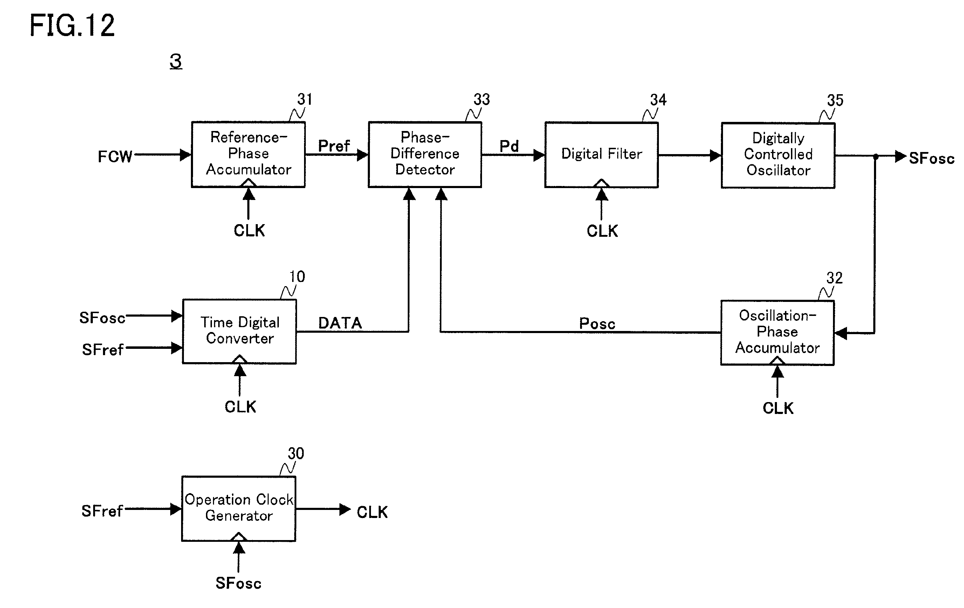

As shown in FIG. 12, the time digital converter of each embodiment is applicable in an all-digital PLL frequency synthesizer. The all-digital PLL frequency synthesizer 3 shown in FIG. 12 includes, in addition to the time digital converter 10, an operation clock generator 30, a reference-phase accumulator 31, an oscillation-phase accumulator 32, a phase-difference detector 33, a digital filter 34, and a digitally controlled oscillator 35, and generates a desired frequency of an oscillation-frequency signal SFosc.

The operation clock generator 30 receives a reference-frequency signal SFref in synchronization with a transition (here, a rising edge) of the oscillation-frequency signal SFosc. This causes an operation clock CLK to be generated. The reference-phase accumulator 31 receives a control value FCW corresponding to a desired frequency of the oscillation-frequency signal SFosc. For example, the control value FCW represents a multiplication factor of the output frequency with respect to a reference frequency ($f_{osc}/f_{ref}$). Here, "$f_{ref}$" denotes the frequency of the reference-frequency signal SFref, and "$f_{osc}$" denotes the frequency of the oscillation-frequency signal SFosc. In addition, the reference-phase accumulator 31 accumulates the control value FCW and provides an accumulated value to the phase-difference detector 33 as a reference-phase value Pref each time a transition (here, a rising edge) of the operation clock CLK occurs. For example, if the control value FCW represents "10.3," the reference-phase value Pref sequentially increases as "10.3," "20.6," "30.9," ... each time a rising edge of the operation clock CLK occurs. The oscillation-phase accumulator 32 accumulates the number of transitions (here, the number of occurrences of rising edges) of the oscillation-frequency signal SFosc. In addition, the oscillation-phase accumulator 32 provides an accumulated value to the phase-difference detector 33 as an oscillation-phase value Posc each time a transition of the operation clock CLK occurs. The oscillation-phase accumulator 32 is formed of, for example, a counter which increments a count value in synchronization with a transition of the oscillation-frequency signal SFosc, a register which outputs a count value of the counter each time a transition of the operation clock CLK occurs, etc.

The time digital converter 10 receives the reference-frequency signal SFref and the oscillation-frequency signal SFosc respectively as the reference signal Sref and the input signal Sin (see FIG. 1), and converts the time difference between the reference-frequency signal SFref and the oscillation-frequency signal SFosc to a digital value DATA. Additionally, the time digital converter 10 (specifically, the decoder 103 (see FIG. 1)) provides the digital value DATA to the phase-difference detector 33 each time a transition of the operation clock CLK occurs.

The phase-difference detector 33 sets a phase-difference value Pd corresponding to the phase difference between the reference-frequency signal SFref and the oscillation-frequency signal SFosc based on both the difference between the reference-phase value Pref and the oscillation-phase value Posc, and the difference between the reference-phase value Pref and the digital value DATA. For example, the phase-difference detector 33 calculates an integer difference value by subtracting the oscillation-phase value Posc from the integer part of the reference-phase value Pref, and calculates a fractional difference value by subtracting the digital value DATA from the fractional part of the reference-phase value Pref, and thus outputs the sum of the integer difference value and the fractional difference value as the phase-difference value Pd. The digital filter 34 operates in synchronization with the transitions of the operation clock CLK, and filters out noise components (high-frequency phase noise) from the phase-difference value Pd set by the phase-difference detector 33. The digitally controlled oscillator 35 sets the frequency of the oscillation-frequency signal SFosc depending on the phase-difference value Pd provided via the digital filter 34. The greater the phase-difference value Pd is, the higher the frequency of the oscillation-frequency signal SFosc which the digitally controlled oscillator 35 generates is.

In a comparison between the reference-phase value Pref and the oscillation-phase value Posc, the phase difference can only be detected at a resolution corresponding to the period of the oscillation-frequency signal SFosc. Meanwhile, in the time digital converter 10, the phase difference can be detected at a resolution higher than the period of the oscillation-frequency signal SFosc (i.e., a resolution corresponding to the delay time (τ) of each delay element DDD). This enables the accuracy of detecting the phase difference to be improved, and as a result, phase noise can be reduced. In addition, since the delay time of the variable delay circuit 101 can be adjusted to a desired amount (an amount appropriate for the frequency of the oscillation-frequency signal SFosc), the frequency variable range of the oscillation-frequency signal SFosc can be broadened, and phase noise can be further reduced.

Note that the all-digital PLL frequency synthesizer 3 may include other components (e.g., a frequency divider to divide the frequency of the oscillation-frequency signal SFosc, a binary converter to convert the oscillation-frequency signal SFosc to a digital signal, etc.). In addition, if the time digital converter 10 shown in FIG. 1 is to be applied in the all-digital PLL frequency synthesizer 3, it is preferable that the calibration operation by the time digital converter 10 be performed before starting the generation of the oscillation-frequency signal SFosc.

(Transceiver and Receiver)

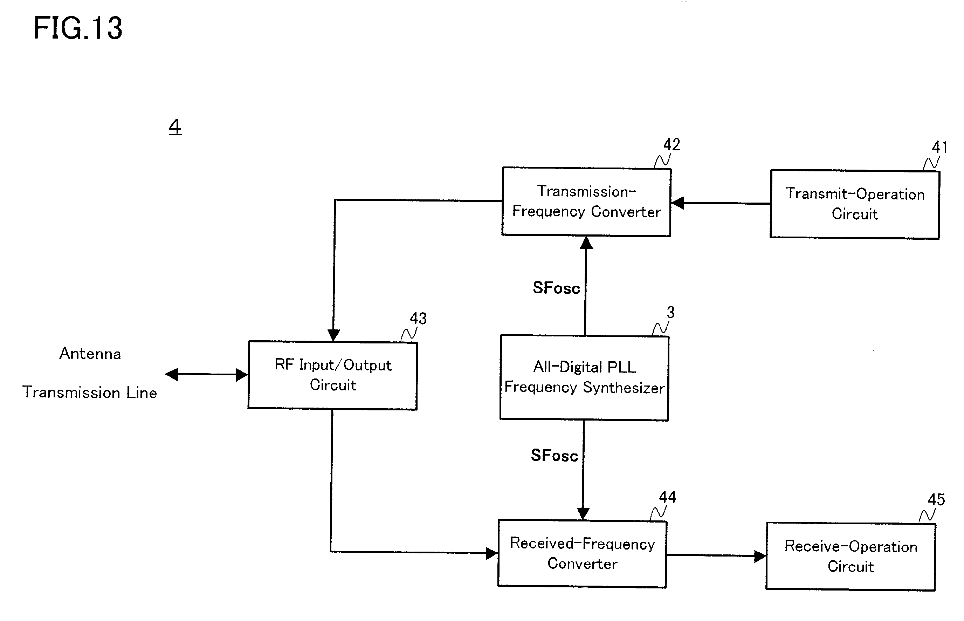

Moreover, as shown in FIG. 13, the all-digital PLL frequency synthesizer shown in FIG. 12 is applicable in wireless transceivers such as mobile phone terminals, and wired transceivers used in power line communication (PLC), etc. The transceiver 4 shown in FIG. 13 includes, in addition to the all-digital PLL frequency synthesizer 3, a transmit-operation circuit 41, a transmission-frequency converter 42, an RF input/output circuit 43, a received-frequency converter 44, and a receive-operation circuit 45. The transmit-operation circuit 41 provides a transmission signal. The transmission-frequency converter 42 converts the frequency of the transmission signal from the transmit-operation circuit 41 using the oscillation-frequency signal SFosc from the all-digital PLL frequency synthesizer 3. The RF input/output circuit 43 outputs the transmission signal whose frequency has been converted by the transmission-frequency converter 42 to an antenna or a transmission line. In addition, the RF input/output circuit 43 inputs a receive signal from the antenna or the transmission line. The received-frequency converter 44 converts the frequency of the receive signal from the RF input/output circuit 43 using the oscillation-frequency signal SFosc from the all-digital PLL frequency synthesizer 3. The receive-operation circuit 45 processes the receive signal whose frequency has been converted by the received-frequency converter 44. In this transceiver 4, since a wide range of frequencies can be generated with a high accuracy by the all-digital PLL frequency synthesizer 3, the supportable frequency range can be broadened compared with conventional ones. Moreover, the all-digital PLL frequency synthesizer 3 shown in FIG. 12 is also applicable in wireless receivers such as tuners used in television receivers, radios, GPS devices, etc., and wired receivers such as cable television receivers, etc.

(Other Embodiments)

Although in the foregoing description, the description has been provided for an example in which the time digital converters, the all-digital PLL frequency synthesizers, etc., operate according to rising edges, they may operate according to falling edges. For example, the frequency measurement circuit 105 may count the number of occurrences of falling edges of the delay signal D(n).

Moreover, each of the decoder 103, the frequency measurement circuit 105, the delay-amount calibration circuit 106, and the delay-amount control circuit 201 may be configured with hardware (a dedicated circuit), or may be implemented by software (program) executed by a CPU or a DSP.

Furthermore, the time digital converter of each embodiment is very useful for, in addition to an all-digital PLL frequency synthesizer, a device which is required to detect a time difference between two signals at a high resolution. For example, if delay times are different between a plurality of paths, control can be performed so that the delay time difference between the paths will be small by measuring the delay time for each path using one of these time digital converters.

INDUSTRIAL APPLICABILITY

As described above, the time digital converters according to the present disclosure can support a wide range of frequencies, and can prevent reduction in the accuracy of detecting a time difference, thus is useful for an all-digital PLL frequency synthesizer, etc., incorporated in a transceiver or a receiver.

DESCRIPTION OF REFERENCE CHARACTERS

| 10, 20 | Time Digital Converter |
|---|---|
| 101 | Variable Delay Circuit |
| 102 | Output Holding Circuit |
| 103 | Decoder |
| 104 | Selector |
| 105 | Frequency Measurement Circuit |
| 106 | Delay-Amount Calibration Circuit |
| DDD | Delay Element |
| FF | Flip-Flop |
| 111 | Period Counter |
| 112 | Frequency Counter |
| 113 | Target-Value Setting Section |
| 114 | Difference-Value Calculation Section |
| 115 | Calibration Control Section |
| 116 | Delay-Amount Setting Section |
| 201 | Delay-Amount Control Circuit |
| 211 | Excessive-Delay Detection Section |
| 212 | Insufficient-Delay Detection Section |
| 213 | Delay-Amount Setting Section |
| 214 | Transition-Bit Count Section |
| 3 | All-Digital PLL Frequency Synthesizer |
| 30 | Operation Clock Generator |
| 31 | Reference-Phase Accumulator |
| 32 | Oscillation-Phase Accumulator |
| 33 | Phase-Difference Detector |
| 34 | Digital Filter |
| 35 | Digitally Controlled Oscillator |
| 4 | Transceiver |
| 41 | Transmit-Operation Circuit |
| 42 | Transmission-Frequency Converter |
| 43 | RF Input/Output Circuit |
| 44 | Received-Frequency Converter |
| 45 | Receive-Operation Circuit |

**Claims**

1. A time digital converter which converts a time difference between a reference signal and an input signal to a digital value, comprising:

a variable delay circuit configured to generate a plurality of delay signals each having a different phase by sequentially delaying a signal provided thereto;
an output holding circuit configured to receive the plurality of delay signals in synchronization with a transition of the reference signal, and to hold the plurality of delay signals as a bit sequence corresponding to the time difference between the reference signal and the signal provided to the variable delay circuit;
a selector configured to provide the input signal to the variable delay circuit in a normal mode, and to provide one of the plurality of delay signals to the variable delay circuit so that the variable delay circuit will be in a ring-oscillation state in a calibration mode;
a frequency measurement circuit configured to count the number of transitions of the one of the plurality of delay signals during a predetermined frequency measurement period; and
a delay-amount calibration circuit configured to, in the calibration mode, adjust a delay time of the variable delay circuit so that the number of transitions counted by the frequency measurement circuit approaches a target value corresponding to a frequency of the input signal.

**2.** The time digital converter of claim 1, wherein
the frequency measurement circuit includes
a period counter configured to count the number of transitions of the reference signal, and
a frequency counter configured to start to count the number of transitions of the one of the plurality of delay signals upon a start of counting by the period counter, and to output a count result when a count value of the period counter reaches a period-setting value for setting the frequency measurement period.

**3.** The time digital converter of claim 2, wherein
the variable delay circuit includes a plurality of cascaded variable delay elements,
and
the selector provides the input signal to a first one of the variable delay elements in the normal mode, and provides an output of the one of the plurality of the variable delay elements to the first one of the variable delay elements so that an oscillation loop is formed in the calibration mode.

**4.** The time digital converter of claim 3, wherein
each of the variable delay elements is an inverter, and
the selector provides an output of an odd-numbered one of the inverters to a first one of the inverters in the calibration mode.

**5.** The time digital converter of claim 3, wherein
each of the variable delay elements is a buffer,
the variable delay circuit further includes an inverter configured to invert an output of one of the plurality of buffers, and
the selector provides an output of the inverter to a first one of the buffers in the calibration mode.

**6.** The time digital converter of claim 3, wherein
the delay time of the variable delay circuit changes as a bias current for the variable delay elements is increased or decreased.

**7.** The time digital converter of claim 3, wherein
the delay time of the variable delay circuit changes as a load capacitance of the variable delay elements is increased or decreased.

**8.** The time digital converter of claim 1, wherein
the delay-amount calibration circuit outputs calibration error information when detecting that the delay time of the variable delay circuit cannot be increased or decreased.

**9.** The time digital converter of any one of claims 1-8, further comprising:

a delay-amount control circuit configured to control the delay time of the variable delay circuit so that the number of transition bits included in a retained result of the output holding circuit falls within an acceptable range.

**10.** The time digital converter of claim 9, wherein
the delay-amount control circuit reduces the delay time of the variable delay circuit when detecting that the number of transition bits included in the retained result of the output holding circuit is greater than an excessive-delay threshold.

**11.** The time digital converter of claim 9, wherein
the delay-amount control circuit increases the delay time of the variable delay circuit when detecting that the number of transition bits included in the retained result of the output holding circuit is less than an insufficient-delay threshold.

**12.** The time digital converter of claim 9, wherein
the delay-amount control circuit outputs control error information when detecting that the delay time of the variable delay circuit cannot be increased or decreased.

**13.** A time digital converter which converts a time difference between a reference signal and an input signal to a digital value, comprising:

a variable delay circuit configured to generate a plurality of delay signals each having a different phase by sequentially delaying the input signal;

an output holding circuit configured to receive the plurality of delay signals in synchronization with a transition of the reference signal, and to hold the plurality of delay signals as a bit sequence corresponding to the time difference between the reference signal and the input signal; and

a delay-amount control circuit configured to control a delay time of the variable delay circuit so that the number of transition bits included in a retained result of the output holding circuit falls within an acceptable range.

14. A digital PLL frequency synthesizer which generates an oscillation-frequency signal having a desired frequency, comprising:

a reference-phase accumulator configured to output a reference-phase value corresponding to the desired frequency;

an oscillation-phase accumulator configured to count the number of transitions of the oscillation-frequency signal, and to output the count value as an oscillation-phase value;

the time digital converter of claim 1 or claim 13 configured to receive a reference-frequency signal and the oscillation-frequency signal respectively as the reference signal and the input signal, and to output a digital value corresponding to a time difference between the reference-frequency signal and the oscillation-frequency signal;

a phase-difference detector configured to set a phase-difference value based on both a difference between the reference-phase value from the reference-phase accumulator and the oscillation-phase value from the oscillation-phase accumulator, and a difference between the reference-phase value and the digital value from the time digital converter; and

a digitally controlled oscillator configured to set a frequency of the oscillation-frequency signal depending on the phase-difference value.

15. A transceiver, comprising:

the digital PLL frequency synthesizer of claim 14;

a transmit-operation circuit configured to output a transmission signal;

a transmission-frequency converter configured to convert a frequency of the transmission signal from the transmit-operation circuit based on the oscillation-frequency signal from the digital PLL frequency synthesizer;

an input/output circuit configured to output the transmission signal whose frequency has been converted by the transmission-frequency converter, and to input a receive signal from the outside;

a received-frequency converter configured to convert a frequency of the receive signal input by the input/output circuit based on the oscillation-frequency signal from the digital PLL frequency synthesizer; and

a receive-operation circuit configured to process the receive signal whose frequency has been converted by the received-frequency converter.

16. A receiver, comprising:

the digital PLL frequency synthesizer of claim 14;

an input circuit configured to input a receive signal from the outside;

a received-frequency converter configured to convert a frequency of the receive signal input by the input circuit based on the oscillation-frequency signal from the digital PLL frequency synthesizer; and

a receive-operation circuit configured to process the receive signal whose frequency has been converted by the received-frequency converter.

# FIG.1

10

MODE

**106** Delay-Amount Calibration Circuit

**105** Frequency Measurement Circuit

START

**115** Calibration Control Section

END

ERR1

ΔC

**114** Difference-Value Calculation Section

C105

**112** Frequency Counter

F111

**111** Period Counter

C0

**113** Target-Value Setting Section

**116** Delay-Amount Setting Section

D(n)

Sref

**104**

D(n)

Sin

MODE

**101**

DDD    DDD    DDD    DDD    DDD

D(1)    D(2)    D(3)    D(n-1)    D(n)

**102**

FF    FF    FF    FF    FF

Sref

Q(1)    Q(2)    Q(3)    Q(n-1)    Q(n)    **103**

Decoder    DATA

EP 2 249 479 A1

17

# FIG.2

Delay Time of Variable Delay Circuit ($11 \times \tau$)

Period of Input Signal ($8 \times \tau$)

$6 \times \tau$

Sin
/D(1)  0
D(2)  0
/D(3)  1
D(4)  1
/D(5)  1
D(6)  1
/D(7)  0
D(8)  0
/D(9)  0
D(10)  0
/D(11)  1
Sref
Q[1:11]  00111100001
DATA  0.75

EP 2 249 479 A1

# FIG.3

```
                          START

                            ↓
                    ┌──────────────────┐  ST101
                    │  Set Delay Time to │
                    │  a Maximum Value   │
                    └──────────────────┘
                            ↓
                    ┌──────────────────────┐  ST102
                    │ Set Variable Delay    │
                    │ Circuit to a Ring-    │
                    │ Oscillation State     │
                    └──────────────────────┘
                            ↓
                    ┌──────────────────┐  ST103
                    │ Start Measurement │
                    │ of Delay Signal   │
                    └──────────────────┘
```

ST105 — Output Frequency Count Value

ST106 — $\triangle C = C105 - C0$

ST107 — $\triangle C > 0$ ?

ST108 — $\triangle C = C_{comp}$

ST109 — Variation Limit?

ST110 — Reduce Delay Time by One Step

ST111 — Start Measurement of Delay Signal Again

ST104 — Has Frequency Measurement Period Elapsed?

ST112 — $\triangle C < C_{comp}$ ?

ST113 — Increase Delay Time by One Step

ST115 — Output Error Information

ST114 — Set to Normal Mode

END

EP 2 249 479 A1

19

## FIG.4

## FIG.5

# FIG.6

MODE

106
Delay-Amount Calibration Circuit

105
Frequency Measurement Circuit

STRAT

115
Calibration Control Section

END

ERR1

114
Difference-Value Calculation Section

ΔC

C105

112
Frequency Counter

F111

111
Period Counter

116
Delay-Amount Setting Section

113
Target-Value Setting Section

C0

D(n)

Sref

101

INV

DDD    DDD    DDD    DDD    DDD

104

D(n)

Sin

MODE

D(1)    D(2)    D(3)    D(n-1)    D(n)

102

FF    FF    FF    FF    FF

Sref

Q(1)    Q(2)    Q(3)    Q(n-1)    Q(n)

103

Decoder    → DATA

EP 2 249 479 A1

# FIG.7

```
                                    ┌─────────────────────┐ ST105
                                    │  Output Frequency   │
                                    │    Count Value      │
                                    └─────────────────────┘
                                              │
        ( START )                             ▼          ST106a
            │                       ┌─────────────────────┐
            ▼            ST101a     │   △C = C0 − C105    │
    ┌─────────────────┐            └─────────────────────┘
    │ Set Delay Time to│                      │
    │  a Minimum Value │                      ▼        ST107              ST112
    └─────────────────┘              ◇ △C > 0 ? ◇──YES──→ ◇ △C < C_comp ? ◇──NO──┐
            │            ST102              │                    │
            ▼                              NO   ST108           YES
    ┌─────────────────────┐        ┌─────────────────┐
    │Set Variable Delay Circuit to│ │  △C = C_comp   │
    │ a Ring-Oscillation State    │ └─────────────────┘
    └─────────────────────┘                │
            │            ST103             ▼        ST109                        ST113a
            ▼                       ◇ Variation Limit? ◇──YES──┐          ┌─────────────────┐
    ┌─────────────────┐                    │                   │          │ Reduce Delay Time│
    │ Start Measurement of│                NO   ST110a          │          │  by One Step    │
    │   Delay Signal   │            ┌─────────────────┐         │          └─────────────────┘
    └─────────────────┘            │ Increase Delay Time│  ┌──────────────┐
            │                       │   by One Step    │  │ Output Error │ ST115
            ▼            ST104      └─────────────────┘  │ Information   │
    ◇ Has Frequency ◇──YES─┐              │              └──────────────┘
    ◇ Measurement Period ◇  │             ▼        ST111        │
    ◇   Elapsed?    ◇      │      ┌─────────────────┐          │           ST114
        │  NO              │      │ Start Measurement of│      ┌──────────────────┐
                           │      │ Delay Signal Again │      │ Set to Normal Mode│
                           │      └─────────────────┘         └──────────────────┘
                                                                       │
                                                                       ▼
                                                                   ( END )
```

EP 2 249 479 A1

# FIG.8

EP 2 249 479 A1

FIG.9

Delay Time of Variable Delay Circuit ( 11 × τ )

Period of Input Signal ( 4 × τ )

Sin

/D(1)  τ  1

D(2)  1

/D(3)  0

D(4)  0

/D(5)  1

D(6)  1

/D(7)  0

D(8)  0

/D(9)  1

D(10)  1

/D(11)  0

Sref

Q[1:11]  11001100110

# FIG.10

Delay Time of Variable Delay Circuit (16 × τ)

Period of Input Signal (11 × τ)

Sin

/D(1)  0

D(2)  0

/D(3)  0

D(4)  0

/D(5)  1

D(6)  1

/D(7)  1

D(8)  1

/D(9)  1

D(10)  1

/D(11)  1

Sref

Q[1:11]  00001111111

EP 2 249 479 A1

# FIG.11

EP 2 249 479 A1

# FIG.12

<u>3</u>

Reference-Phase Accumulator (31) — input FCW, CLK; output Pref → Phase-Difference Detector (33) → Pd → Digital Filter (34), CLK → Digitally Controlled Oscillator (35) → SFosc

Time Digital Converter (10) — inputs SFosc, SFref, CLK; output DATA → Phase-Difference Detector

Oscillation-Phase Accumulator (32) — CLK; output Posc → Phase-Difference Detector

Operation Clock Generator (30) — input SFref, SFosc; output CLK

EP 2 249 479 A1

# FIG.13

EP 2 249 479 A1

4

```
                                        ┌──────────────────┐  42          ┌──────────────────┐  41
                                        │  Transmission-   │              │ Transmit-Operation│
                                    ┌──▶│Frequency Converter│◀────────────│      Circuit      │
                                    │   └──────────────────┘              └──────────────────┘
                                    │            ▲
                                    │            │ SFosc
                                    │            │                3
                                    │   ┌──────────────────┐
   Antenna                          │   │  All-Digital PLL │
                    ┌────────────┐  │   │Freqency Synthesizer│
◀──────────────────▶│ RF Input/Output│─┘   └──────────────────┘
   Transmission Line │   Circuit   │  43           │
                    └────────────┘             │ SFosc
                           │                   ▼
                           │        ┌──────────────────┐  44          ┌──────────────────┐  45
                           └───────▶│Received-Frequency│─────────────▶│ Receive-Operation │
                                    │    Converter     │              │      Circuit      │
                                    └──────────────────┘              └──────────────────┘
```

# FIG.14

EP 2 249 479 A1

FIG.15

Delay Time of Delay Circuit ($10 \times \tau$)

Period of Input Signal ($8 \times \tau$)

Sin

/D(1)  0

D(2)  0

/D(3)  1

D(4)  1

/D(5)  1

D(6)  1

/D(7)  0

D(8)  0

/D(9)  0

D(10)  0

Sref

Q[1:10]  0011110000

EP 2 249 479 A1

## INTERNATIONAL SEARCH REPORT

| International application No. |
|---|
| PCT/JP2009/000603 |

A. CLASSIFICATION OF SUBJECT MATTER
*H03K5/26*(2006.01)i, *G01R23/10*(2006.01)i, *H03L7/08*(2006.01)i, *H03L7/081* (2006.01)i, *H03L7/099*(2006.01)i

According to International Patent Classification (IPC) or to both national classification and IPC

B. FIELDS SEARCHED

Minimum documentation searched (classification system followed by classification symbols)
H03K5/26, G01R23/10, H03L7/08, H03L7/081, H03L7/099

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 5-259907 A (Nippondenso Co., Ltd.), 08 October, 1993 (08.10.93), Full text; all drawings & US 5396247 A          & EP 0561331 A2 | 1-16 |
| A | JP 9-218281 A (Denso Corp.), 19 August, 1997 (19.08.97), Full text; all drawings (Family: none) | 1-16 |
| A | JP 2007-110370 A (Fujitsu Ltd.), 26 April, 2007 (26.04.07), Full text; all drawings & US 2007/0085570 A1 | 1-16 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 25 February, 2009 (25.02.09) | Date of mailing of the international search report 10 March, 2009 (10.03.09) |
|---|---|
| Name and mailing address of the ISA/ Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/000603

| C (Continuation). | DOCUMENTS CONSIDERED TO BE RELEVANT | |
|---|---|---|
| Category* | Citation of document, with indication, where appropriate, of the relevant passages | Relevant to claim No. |
| A | JP 2002-76886 A (Texas Instruments Inc.), 15 March, 2002 (15.03.02), Full text; all drawings & US 6429693 B1 & EP 1178609 A2 | 1-16 |

Form PCT/ISA/210 (continuation of second sheet) (April 2007)

**EP 2 249 479 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002076886 A